**Europäisches Patentamt**

**European Patent Office**

**Office européen des brevets**

(11) Veröffentlichungsnummer: **0 330 972**

**A2**

## (12) EUROPÄISCHE PATENTANMELDUNG

(21) Anmeldenummer: **89103005.8**

(22) Anmeldetag: **21.02.89**

(51) Int. Cl.4: **B29C 67/14 , B29C 43/12 , B29C 43/36 , B32B 17/10 , H05K 3/46**

(30) Priorität: **29.02.88 DE 3806427**

(43) Veröffentlichungstag der Anmeldung:
**06.09.89 Patentblatt 89/36**

(84) Benannte Vertragsstaaten:
**AT BE CH DE FR GB IT LI NL**

(71) Anmelder: **Siemens Aktiengesellschaft**
**Wittelsbacherplatz 2**
**D-8000 München 2(DE)**

(72) Erfinder: **Abele, Walter**
**Brahmstrasse 27**
**D-8900 Augsburg(DE)**
Erfinder: **Müller, Georg, Dipl.-Ing.**
**Blütenstrasse 1**
**D-8901 Rettenbergen(DE)**

(54) **Autoklaven-Laminiervorrichtung für Mehrlagenleiterplatten.**

(57) Die Erfindung bezieht sich auf eine Autoklaven-Laminiervorrichtung zur Herstellung von Mehrlagenleiterplatten, bei dem die zu laminierenden, in einer mit Überdruck versehbaren und aufheizbaren Kammer befindlichen, zwischen zwei Preßplatten liegenden Leiterplattenstapel mit einer Umhüllung umgeben sind, die zusammen mit ihrer Auflagefläche einen allseits umschlossenen Raum ergibt, aus dem durch Absaugen des darin befindlichen Gases eine Unterdruckkammer entsteht. Diese Unterdruckkammer wurde bisher durch eine Folie gebildet, die mit doppelseitigem Klebeband zusammengehalten wurde, wobei zwischen dem Leiterplattenstapel und dieser Folie ein Textilflies zur Herstellung von Absaugkanälen gelegt wird. Durch manuelle Herstellung diesr Vakuumkammer war aber bisher eine Automatisierung des Verfahrens nicht möglich.

Diesen Nachteil verhindert die Erfindung dadurch, daß die Unterdruckkammer (1) durch eine in einen zweiteiligen Dichtrahmen (2a,2b) einspannbare, aus temperaturbeständigem Material bestehende, über das Leiterplattenstapel (4) gespannte Dichtmatte (3) gebildet wird. Zwischen Dichtmatte (3) und Leiterplattenstapel (4) ist ein teflonisiertes Glasgewebe (5) zur Bildung der Absaugekanäle gelegt und die zur Absaugung des Gases erforderlichen Absaugenuten (6) sind in den Legetisch (7), auf dem Leier-plattenstapel (4) liegt, unmittelbar eingebracht.

FIG 1

## Autoklaven-Laminiervorrichtung für Mehrlagenleiterplatten

Die Erfindung betrifft eine Autoklaven-Laminiervorrichtung zur Herstellung von Mehrlagenleiterplatten, bei dem die zu laminierenden, in einer mit Überdruck versehbaren und aufheizbaren Kammer befindlichen, zwischen zwei Preßplatten liegenden Leiterplattenstapel mit einer Umhüllung umgeben sind, die zusammen mit ihrer Auflagefläche einen allseits umschlossenen Raum ergibt, aus dem durch Absaugen des darin befindlichen Gases, wie z.B. Luft, eine Unterdruckkammer entsteht.

In dem Prospekt "Leiterplattenseminar 1985" der Firma Birkle-Maschinenfabrik Stuttgart, wird ein Autoklaven-Laminierverfahren zur Herstellung von Mehrlagenleiterplatten beschrieben. Dieses Verfahren beruht darauf, daß Leiterplattenstapel auf einem Legetisch in eine Kammer eingeführt werden, die während des Laminierprozesses aufgeheizt und mit einem Überdruck versehen werden. Die Leiterplattenstapel selbst, an deren Ober- und Unterseite jeweils eine Preßplatte angeordnet ist, werden mit großem manuellen Aufwand mit einer Folie umgeben, die mit einem doppelseitigen Klebeband zusammengehalten wird, wodurch eine Kammer entsteht, die dann abgesaugt werden kann. Die Absaugung erfolgt über eine Bohrung im Legetisch. Damit das eigentliche Preßwerkzeug (untere Preßplatte) nicht plan aufliegt und die Absaugöffnung abdichtet, ist zwischen Werkzeug und Legetisch eine Nutenplatte erforderlich. Um die Absaugung des Preßpaketes zu ermöglichen, wird ein Textilflies zwischen Folie und den Leitungsplattenstapel gelegt, so daß sich Kanäle bilden können, durch die der Gastransport erfolgt.

Diese Art der Bildung der Vakuumkammer ist mit hohem manuellen Aufwand verbunden. Eine Automatisierung dieser Vorgehensweise ist nicht möglich, und der Verfahrenserfolg ist von der manuellen Geschicklichkeit des Durchführenden abhängig. Besonders ungünstig ist die Verwendung von Textilflies, da dieses mit dem austretenden Harz am Preßpaket festklebt. Um die Evakuierung der Preßpakete zu ermöglichen, muß jedes einzelne Preßwerkzeug mit einer Nutenplatte zur Absaugung versehen werden. Folie, Klebeband und Flies sind nur für eine einmalige Anwendung geeignet. Diese Vorgehensweise zur Erstellung der Vakuumkammer beeinträchtigt daher die Verfahrensanwendung.

Aufgabe der vorliegenden Erfindung ist es, den Aufbau der Vakuumkammer im Hinblick auf eine Automatisierung zu verbessern.

Zur Lösung dieser Aufgabe wird die Autoklaven-Laminiervorrichtung nach der Erfindung derart ausgebildet, daß. die Unterdruckkammer durch einen in einen zweiteiligen Dichtrahmen einspannbare, aus temperaturbeständigem Material, wie z.B. Silicongummi, bestehende, über das Leiterplattenstapel gespannte Dichtmatte gebildet wird, daß zwischen Dichtmatte und Leiterplattenstapel ein teflonisiertes Glasgewebe liegt, und daß die zur Absaugung des Gases erforderlichen Absaugnuten in den Legetisch, auf dem die Leiterplattenstapel liegen, eingebracht sind.

Durch diese Maßnahmen wird erreicht, daß der Vakuiervorgang automatisiert werden kann. Zudem ist damit eine gleichbleibende Qualität des Verpressens der einzelnen Leiterplatten gewährleistet, da diese nicht mehr von der manuellen Geschicklichkeit des jeweils Durchführenden abhängig ist. Da die Dichtmatte und das Glasgewebe mehrfach verwendet werden können, wird dadurch der Materialverbrauch und damit auch der anfallende Abfall wesentlich veringert.

Anhand der Ausführungsbeispiele nach den FIG 1 bis 4 wird die Erfindung näher erläutert.

Es zeigen

FIG 1 den Vakuumrahmen mit eingespannter Dichtmatte,

FIG 2 den Vakuumrahmen allein,

FIG 3 die Befestigungsvorrichtung für die Verschraubung der beiden Vakuumrahmenteile und

FIG 4 Legetisch für den Mehrlagenleiterplattenstapel.

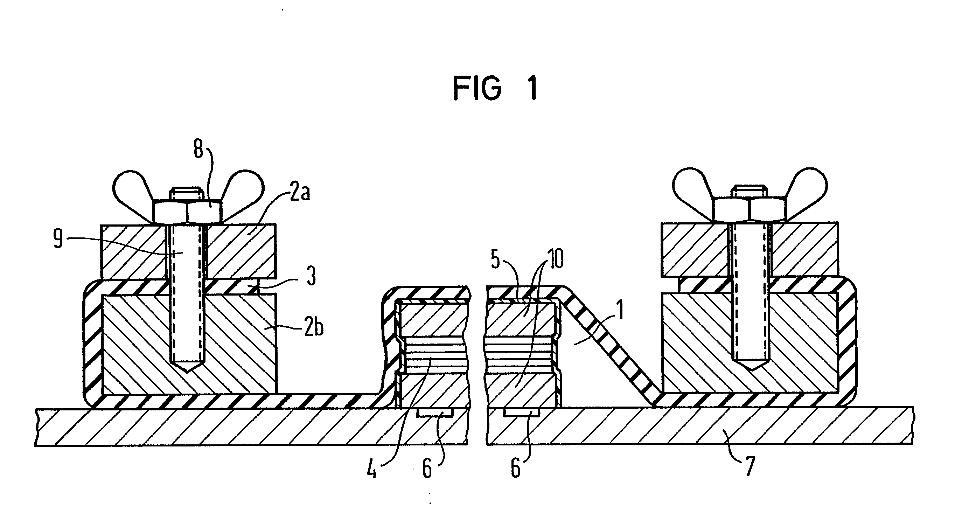

In FIG 1 ist auf der rechten Seite die Bildung der Vakuumkammer vor dem Absaugen des Gases, und auf der linken Seite die Bildung der Vakuumkammer nach dem Absaugen des Gases dargestellt. Auf den Legetich 7, der mit Absaugenuten 6 versehen ist, wird das Leiterplattenstapel 4, das zwischen zwei Preßwerkzeugen 10 (Preßplatten) liegt, aufgelegt und zunächst mit einem teflonisierten Glasgewebe 5 umgeben. Anschließend wird die Dichtmatte 3 über den so zu verpressenden Leiterplattenstapel gelegt, wobei die Dichtmatte zwischen dem Oberteil 2a und dem Unterteil 2b des Dichtrahmens mit Hilfe einer aus einem Schraubbolzen 9 und einer Flügelmutter 8 bestehenden Schraubverbindung geklemmt ist. Bevor die nun so gebildete Vakuumkammer I abgesaugt ist, liegt die Dichtmatte, wie auf der rechten Seite des Bildes dargestellt, nur lose auf dem Leiterplattenstapel auf. Erst nach dem Absaugvorgang wird diese Dichtmatte, wie auf der linken Seite der Darstellung ersichtlich, fest an das Leiterplattenstapel von drei Seiten angepaßt und damit ist eine exakte Halterung des Leiterplattenstapels gewährleistet, wobei zugleich auch die zwischen den Leiterplatten befindliche Luft entfernt ist. Nunmehr kann dieses so gebildete Stapel in der eingangs beschriebenen Überdruckkammer, die zudem auf entsprechende Temperaturen aufheizbar ist, verpreßt werden.

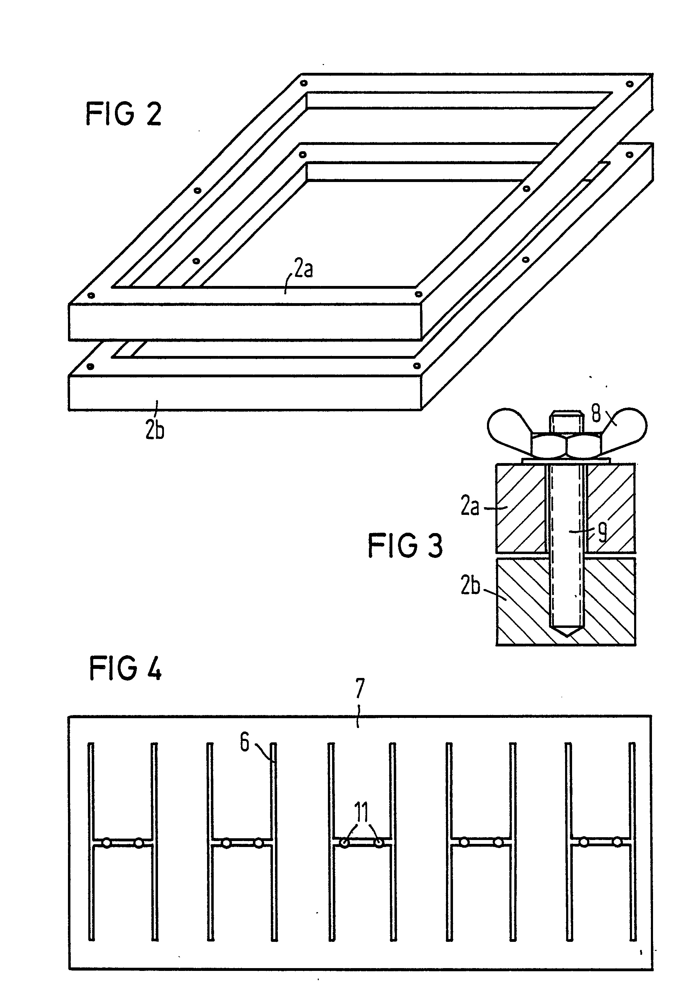

In FIG 2 ist das obere und untere Rahmenteil des Dichtrahmens dargestellt. Im unteren Dichtrahmen befinden sich in entsprechend gewählten Abständen Gewindebolzen 9, wie in FIG 3 dargestellt. Der obere Rahmen wird in diesen Gewindebolzen geführt und mit dem unteren Rahmen über Flügelmuttern 8 verschraubt.

Durch das Anbringen der Absaugnuten unmittelbar im Legetisch wird der Nachteil, daß jedes einzelne Preßwerkzeug mit einer zusätzlichen Nutenplatte versehen werden muß, beseitigt.

Die Nuten sind quer zur Längsrichtung des Legetisches angeordnet und jeweils zwei Nuten über einen Quersteg, an dem sich jeweils zwei Vakuumansaugeöffnungen befinden, verbunden.

**Ansprüche**

Autoklaven-Laminiervorrichtung zur Herstellung von Mehrlagenleiterplatten, bei dem die zu laminierenden in einer mit Überdruck versehbaren und aufheizbaren Kammer befindlichen, zwischen zwei Preßplatten liegenden Leiterplattenstapel mit einer Umhüllung umgeben sind, die zusammen mit ihrer Auflagefläche einen allseits umschlossenen Raum ergibt, aus dem durch Absaugen des darin befindlichen Gases, wie z.B. Luft, eine Unterdruckkammer entsteht, **dadurch gekennzeichnet,** daß die Unterdruckkammer (1) durch einen in einen zweiteiligen Dichtrahmen (2a,2b) einspannbare, aus temperaturbeständigem Material, wie z.B. Silicongummi, bestehende, über das Leiterplattenstapel (4) gespannte Dichtmatte (3) gebildet wird, daß zwischen Dichtmatte (3) und Leiterplattenstapel (4) ein teflonisiertes Glasgewebe (5) liegt, und daß die zur Absaugung des Gases erforderlichen Absaugnuten (6) in den Legetisch (7), auf dem die Leiterplattenstapel (4) liegen, eingebracht sind.

FIG 1

FIG 2

2a

2b

FIG 3

8

2a

9

2b

FIG 4

7

6

11